Europäisches Patentamt

European Patent Office

Office européen des brevets

(19)

(11) **EP 0 981 762 B1**

(12) **EUROPÄISCHE PATENTSCHRIFT**

(45) Veröffentlichungstag und Bekanntmachung des Hinweises auf die Patenterteilung:
**17.08.2005 Patentblatt 2005/33**

(21) Anmeldenummer: **98952955.7**

(22) Anmeldetag: **20.11.1998**

(51) Int Cl.$^7$: **G01R 33/565**

(86) Internationale Anmeldenummer:
**PCT/IB1998/001841**

(87) Internationale Veröffentlichungsnummer:
**WO 1999/028758 (10.06.1999 Gazette 1999/23)**

(54) **MR-VERFAHREN**

MAGNETIC RESONANCE METHOD

PROCEDE PAR RESONANCE MAGNETIQUE

(84) Benannte Vertragsstaaten:
**DE FR GB NL**

(30) Priorität: **29.11.1997 DE 19753093**

(43) Veröffentlichungstag der Anmeldung:
**01.03.2000 Patentblatt 2000/09**

(73) Patentinhaber:
• **Koninklijke Philips Electronics N.V.**
**5621 BA Eindhoven (NL)**
Benannte Vertragsstaaten:
**FR GB NL**
• **Philips Intellectual Property & Standards GmbH**
**20099 Hamburg (DE)**
Benannte Vertragsstaaten:
**DE**

(72) Erfinder:
• **ALDEFELD, Bernd**
**NL-5656 AA Eindhoven (NL)**
• **SCHOMBERG, Hermann**
**NL-5656 AA Eindhoven (NL)**
• **HOLZ, Dietrich**
**NL-5656 AA Eindhoven (NL)**

(74) Vertreter: **Volmer, Georg, Dipl.-Ing. et al**
**Philips Intellectual Property & Standards GmbH,**
**Postfach 50 04 42**
**52088 Aachen (DE)**

(56) Entgegenhaltungen:
**EP-A- 0 228 056**

**Beschreibung**

Bei MR-Verfahren (MR= Magnetresonanz) ist die genaue Kenntnis des zeitlichen Verlaufs des Magnetfeldes, insbesondere seiner sich räumlich linear ändernden Komponente (Gradientenfeld), erforderlich. Wenn dieser Verlauf nicht bekannt ist, können bei einer Rekonstruktion Artefakte in MR-Bildern auftreten, und es kann die Kernmagnetisierung durch räumlich selektive Hochfrequenzimpulse in einem von dem vorgesehenen Bereich abweichenden Bereich angeregt werden.

Bei den üblichen MR-Verfahren wird unterstellt, daß das Magnetfeld, insbesondere das Gradientenfeld, den gewünschten, von einem Waveform-Generator vorgegebenen zeitlichen Verlauf hat. Dies ist aber nur dann der Fall, wenn in den zur Erzeugung der Gradientenfelder erforderlichen Gradientenspulen keine Wirbelströme auftreten und wenn die Gradientenverstärker, die die Ströme für die Gradientenspulen liefern, exakt linear sind.

Um den zeitlichen Verlauf des Gradientenfeldes trotz Wirbelstromverlusten dem gewünschten Verlauf anzupassen, ist es aus der EP-B 228 056 bekannt, die Gradienten-Waveform oder -Pulsform dem Gradientenverstärker über ein Preemphasis-Filter zuzuführen, das ein zur Gradientenspule inverses Übertragungsverhalten hat. Das Übertragungsverhalten der Gradientenspule wird in einem vorangehenden Meßverfahren anhand ihrer Impulsantwort bestimmt, und die Filterparameter werden in Abhängigkeit von den Meßwerten gewählt. Auch dieses Verfahren kann nur funktionieren, wenn die gesamte Kette der elektronischen Komponenten des Gradientenkanals als ein lineares und zeitinvariantes System angesehen werden kann. Nichtlineare Kennlinien der Gradientenverstärker und temperaturabhängige Verstärkungsfaktoren stehen diesen Bedingungen aber entgegen.

Bei einem aus Proc ISMRM 1996, 1405 bekannten Verfahren werden die Ströme in den Gradientenspulen gemessen, und es wird unterstellt, daß der zeitliche Verlauf des Gradientenfeldes dem zeitlichen Verlauf des gemessenen Stromes entspricht. Dabei sind jedoch Wirbelstromeffekte nicht berücksichtigt. Bei einem anderen bekannten Verfahren (SMR 94, 484) wird das Magnetfeld direkt im Magneten gemessen und die k-Raumtrajektorien daraus bestimmt. Ein großer Nachteil dieses Verfahrens ist aber, daß eine solche Messung für jede verwendete MR-Sequenz gesondert durchgeführt werden muß. Dies erfordert hohen Zeitaufwand und verhindert u.a. das beliebige Verändern der MR-Pulssequenz während der Datenerfassung (z.B. interaktives MR).

Aufgabe der vorliegenden Erfindung ist es, ein Verfahren anzugeben, das auf einfache Weise eine genaue. Bestimmung des zeitlichen Verlaufs des Magnetfeldes, insbesondere des Gradientenfeldes, gestattet.

Diese Aufgabe wird gelöst durch ein MR-Verfahren gemäß Anspruch 1.

Die Erfindung basiert auf der Erkenntnis, daß die Gradientenspulen selbst lineare Systeme mit zeitlich konstantem Übertragungsverhalten darstellen.Es genügt daher, die Impulsantworten dieser Systeme einmal zu messen; bei späteren Untersuchungen wird lediglich der zeitliche Verlauf des Stromes gemessen, und daraus und aus der gespeicherten Impulsantwort wird der zeitliche Verlauf des Magnetfeldes errechnet - z.B. durch Faltung des Stromes mit der gespeicherten Impulsantwort. Damit ist eine genaue Bestimmung des zeitlichen Verlaufs des Magnetfeldes möglich. Gleichwohl werden dabei keinerlei Anforderungen an die Linearität des Gradientenverstärkers gestellt (es können daher auch billige Verstärker mit gewissen Nichtlinearitäten benutzt werden). Es kommt auch nicht darauf an, daß die Wirbelstromeffekte besonders niedrig sind; denn diese finden ihren Niederschlag in der einmal gemessenen Impulsantwort.

Die in Anspruch 2 beschriebene Weiterbildung nutzt die durch die Erfindung erhaltene genauere Kenntnis des zeitlichen Verlaufs der sich räumlich linear ändernden Komponente des Magnetfeldes (die im folgenden auch als Gradientenfeld bezeichnet wird) zu einer Verbesserung der Rekonstruktion aus. Bei den üblichen Verfahren werden der Rekonstruktion k-Raum-Trajektorien zugrunde gelegt, die sich aus dem gewünschten Verlauf der Gradientenfelder oder nur aus einer Strommessung ohne Beerücksichtigung der Wirbelströme ergeben. Wenn die tatsächlichen k-Raum-Trajektorien aber nicht diesen Werten entsprechen, ergeben sich Bild-Artefakte. Bei der Erfindung werden stattdessen der Rekonstruktion die tatsächlichen k-Raum-Trajektorien zugrundegelegt, die sich durch Messung und Rechnung ergeben. Der k-Raum wird dann zwar nicht mehr auf der idealen k-Raum-Trajektorie abgetastet, doch erlauben verschiedene Verfahren, u.a. das sogenannte Gridding-Verfahren, auch in diesen Fällen eine einwandfreie Rekonstruktion. Es sind keine von der jeweiligen MR-Sequenz abhängigen vorbereitenden Messungen erforderlich.

Ungünstig aufgebaute Gradientenspulen können außer der erwünschten, sich räumlich linear ändernden Komponente des Magnetfeldes auch Komponenten höherer Ordnung erzeugen, die sich räumlich mit der zweiten oder einer höheren Potenz ändern. Diese können ebenfalls zu Bildfehlern führen. Wenn aber Rekonstruktionsverfahren benutzt werden, die bei der Rekonstruktion auch solche Komponenten berücksichtigen, kann die in Anspruch 3 angegebene Weiterbildung zu einer verbesserten Rekonstruktion führen.

Die in Anspruch 4 angegebene Weiterbildung gestattet das Design von Hochfrequenzimpulsen, die die Kernmagnetisierung nur in vorgegebenen räumlichen Bereichen anregen.

Anspruch 5 beschreibt eine MR-Anordnung zur Durchführung des MR-Verfahrens.

Die Erfindung wird nachstehend anhand der Zeichnungen näher erläutert. Es zeigen:

Fig. 1 ein Prinzipschema eines erfindungsgemäßen MR-Gerätes,

Fig. 2 den räumlichen Verlauf verschiedener Komponenten des Magnetfeldes einer (Gradienten-)Spule,

Fig. 3 die Verfahrensschritte zur Bestimmung der Impulsantwort und

Fig. 4 die Verfahrensschritte, um mit Hilfe der Impulsantwort und des gemessenen Stromverlaufs ein MR-Bild zu rekonstruieren.

Fig. 5 den zeitlichen Verlauf des in die Gradientenspule fließenden Stromes und des dadurch erzeugten Gradientenfeldes.

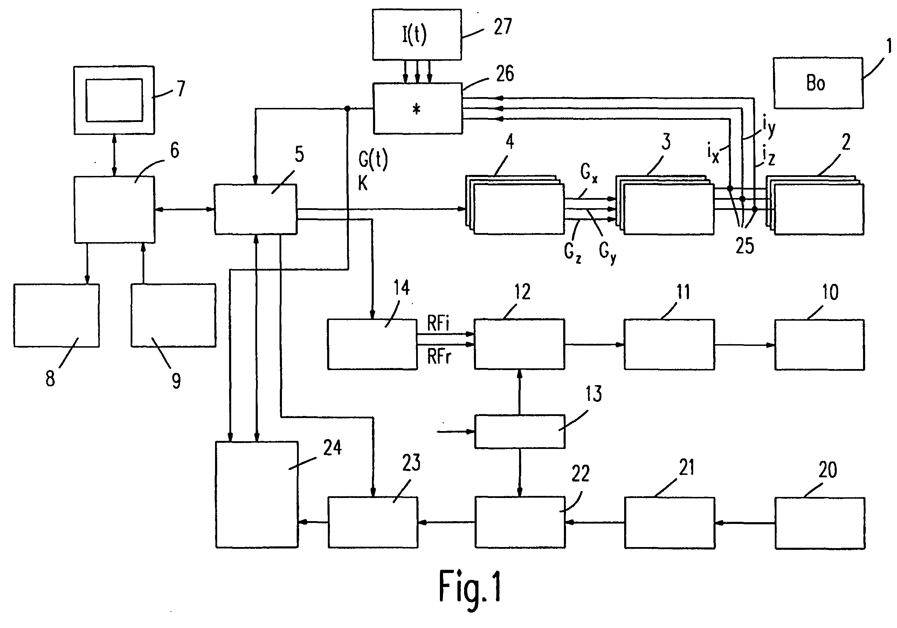

In Fig. 1 ist mit 1 ein schematisch dargestellter Hauptfeldmagnet bezeichnet, der in einem nicht näher dargestellten Untersuchungsbereich ein in z-Richtung verlaufendes, stationäres und im wesentlichen homogenes Magnetfeld mit einer Stärke von z.B. 1,5 Tesla erzeugt. Die z-Richtung verläuft dabei horizontal und in Längsrichtung eines nicht näher dargestellten Untersuchungstisches, auf dem sich während einer MR-Untersuchung ein Patient befindet.

Weiterhin ist eine Gradientenspulenanordnung 2 vorgesehen, die drei Spulensysteme umfaßt, mit denen in z-Richtung verlaufende magnetische Gradientenfelder $G_x$, $G_y$ bzw. $G_z$ mit einem Gradienten in x-, y- bzw. z-Richtung erzeugt werden können. Der zeitliche Verlauf der magnetischen Gradientenfelder wird von einem Waveform-Generator 4 vorgegeben - und zwar für die x-, y- und z-Richtung gesondert. Der Waveform-Generator 4 wird von einer Rechen- und Steuereinheit 5 gesteuert, die nach Vorgabe des Untersuchungsverfahrens (z.B. eine EPI-Sequenz) und dessen geometrischer Parameter (z.B. Lage der abzubildenden Schicht) den erforderlichen zeitlichen Verlauf der magnetischen Gradientenfelder $G_x$, $G_y$, $G_z$ berechnet und in den Waveform-Generator lädt.

Bei einer MR-Untersuchung werden diese Signale aus dem Waveform-Generator ausgelesen und Verstärkern 3 zugeführt, die daraus die für die drei Spulensysteme der Gradientenspulenanordnung 2 erforderlichen Ströme $i_x$, $i_y$, $i_z$ erzeugen.

Die Steuereinheit 5 wirkt außerdem noch mit einer Workstation 6 zusammen. Die Workstation ist mit einem Monitor 7 zur Wiedergabe von MR-Bildern versehen. Über eine Tastatur 8 oder eine interaktive Eingabeeinheit 9, z. B. einen Lichtgriffel, sind Eingaben möglich, wie z.B. die Vorgabe des bei einer MR-Untersuchung anzuwenden MR-Verfahrens, die Lage der abzubildenden Schichten usw.

Die Kernmagnetisierung im Untersuchungsbereich kann durch Hochfrequenzimpulse einer Hochfrequenzspule 10 angeregt werden, die an einen Hochfrequenzverstärker 11 angeschlossen ist, der die Ausgangssignale eines Hochfrequenzsenders 12 verstärkt. In dem Hochfrequenzsender 12 werden die (komplexen) Einhüllenden der Hochfrequenzimpulse mit den von einem Oszillator 13 gelieferten Trägerschwingungen moduliert, deren Frequenz der Larmorfrequenz (bei einem Hauptmagnetfeld von 1,5 Tesla ca. 63 MHz) entspricht. Die (komplexe) Einhüllende wird von der Rechen- und Steuereinheit 5 in einen Generator 14 geladen, der mit dem Sender 12 gekoppelt ist.

Die im Untersuchungsbereich erzeugten MR-Signale werden von einer Empfangsspule 20 aufgenommen und von einem Verstärker 21 verstärkt. Das verstärkte MR-Signal wird in einem Quadraturdemodulator 22 durch zwei um 90° gegeneinander versetzte Trägerschwingungen des Oszillators demoduliert, so daß zwei Signale erzeugt werden, die als Realteil und als Imaginärteil eines komplexen MR-Signal aufgefaßt werden können. Diese Signale werden einem Analog-Digital-Wandler 23 zugeführt, der daraus MR-Daten bildet - falls die Steuereinheit 5 ihn nicht blockiert. Die MR-Daten werden in einer Rekonstruktionseinheit 24 gespeichert, die im Zusammenwirken mit der Workstation 6 aus den von einer Vielzahl von MR-Signalen abgeleiteten MR-Daten MR-Bilder rekonstruiert, die die Kernmagnetisierung im Untersuchungsbereich darstellen.

Erfindungsgemäß werden die Ströme an den Eingängen der drei Gradientenspulen 2 mit je einem Stromsensor 25 gemessen, der somit ein dem zeitlichen Verlauf des Stromes $i_x(t)$, $i_y(t)$ und $i_z(t)$ proportionales Signal liefert. In einer Recheneinheit 26 werden die den am Eingang der Gradientenspulen 2 gemessenen Strömen entsprechenden Signale mit den zuvor gemessenen, in einem Speicher 27 gespeicherten Impulsantworten der durch die drei Gradientenspulen für die x-, y- und z-Richtung gebildeten Systeme gefaltet. Als Ergebnis liefert die Recheneinheit 26 den zeitlichen Verlauf der von den Gradientenspulen erzeugten Magnetfelder, zumindest aber der Gradientenfelder G(t) bzw. der daraus in bekannter Weise durch Integration abgeleiteten K-Werte für die x-. y- bzw. z-Richtung. Die so ermittelten Werte werden der Rekonstruktionseinheit 24 zwecks Verbesserung der Rekonstruktion und/oder der Recheneinheit 5 zugeführt, die daraus den zeitlichen Verlauf der Umhüllenden der Hochfrequenzimpuls bzw. der magnetischen Gradientenfelder für räumlich selektive Hochfrequenzimpulse ableitet.

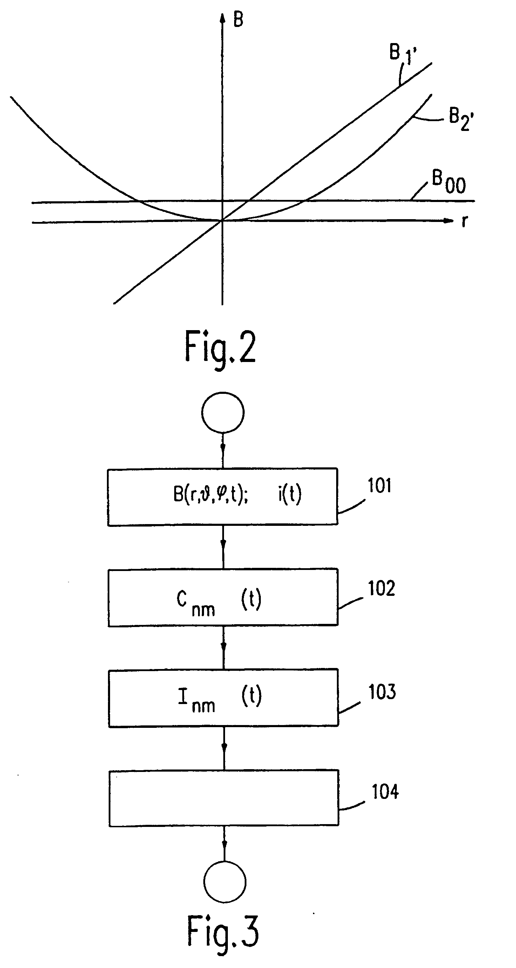

Der Hintergrund und die Durchführung des Verfahrens wird nachstehend der Fig. 2 bis 5 erläutert.

Es ist bekannt, daß der räumliche und zeitliche Verlauf des von einer (Gradienten-)Spule erzeugten Magnetfeldes B näherungsweise der Gleichung

$$B(r,\vartheta,\varphi,t) \approx \sum_{n=0}^{N} \sum_{m=-n}^{+n} c_{nm}(t)\, Y_{nm}(r,\vartheta,\varphi) \tag{1}$$

genügt. Dabei stellen t die Zeit und die Werte r, $\vartheta$, $\varphi$ die Parameter eines im Koordinatenursprung befindlichen Kugelkoordinatensystems dar. In diesem Kugelkoordinatensystem bezeichnet r den Abstand eines Meßpunktes vom Koordinatenursprung, $\vartheta$ den Winkel, den der den Koordinatenursprung mit dem Meßpunkt verbindende Vektor r mit der z-Achse einschließt, und $\varphi$ den Winkel, den die Projektion des Vektors auf die x-y-Ebene mit der x-Achse einschließt. $Y_{nm}$ sind die Kugelfunktionen, und $c_{nm}(t)$ stellen zeitabhängige Koeffizienten dar, die die Spule vollständig charakterisieren können. Die Näherung nach Gleichung 1 ist umso besser, je größer N ist.

Die Kugelfunktionen $Y_{nm}$ (r, $\vartheta$, $\varphi$) sind durch die Gleichungen

$$Y_{nm}(r,\vartheta,\varphi,)=r^{n}\, P_{nm}(\cos\vartheta)\cos m\varphi; \qquad m\geq 0 \tag{2}$$

bzw. durch

$$Y_{nm}(r,\vartheta,\varphi,) = r^{n}\, P_{n\_m\_}(\cos\vartheta)\sin|m|\varphi; \qquad m<0 \tag{3}$$

definiert. Die Terme $P_{nm}(\cos\vartheta)$ stellen dabei die sogenannten zugeordneten (aasociated) Legendre-Funktionen des Arguments $\cos\vartheta$ dar. Gleichung 1 besagt, daß man sich das Magnetfeld einer jeden Spule aus der Überlagerung von Magnetfeldkomponenten zusammengesetzt denken kann, die sich räumlich gar nicht, linear oder mit einer höheren Potenz als Funktion von r ändern. Jeder durch n, m definierte Summand auf der rechten Seite von Gleichung 1 kann als partielles Magnetfeld aufgefaßt werden, das sich in einer bestimmten Weise räumlich ändert. Dies ist in Fig 2 dargestellt, wo sich die durch n=1 definierte Komponente $B_1$, linear, die durch n=2 definierte Komponente $B_2$, quadratisch und die durch n=0 definierte Komponente $B_{00}$ gar nicht räumlich ändern.

Die zeitabhängigen Koeffizienten $c_{nm}(t)$ geben das Gewicht an, mit dem diese partiellen Magnetfelder in dem Gesamtmagnetfeld B enthalten sind. Gradientenspulen sind im allgemeinen so dimensioniert, daß nur ein einziger Koeffizient - bei der Gradientenspule für die x-Richtung z.B. der Koeffizient $c_{11}$ von Null verschieden ist, während alle anderen Koeffizienten demgegenüber im Idealfall vernachlässigbar sind.

Die Koeffizienten $c_{nm}$ lassen sich mit einer harmonischen Analyse (series expansion) berechnen, wenn der zeitliche Verlauf des Magnetfeldes B (r, $\vartheta$, $\varphi$ t) an einer Reihe von Meßpunkten, z.B. auf der Oberfläche einer Kugel um den Koordientenursprung, gemessen wird. Da $Y_{nm}$ (r, $\vartheta$, $\varphi$) nämlich allgemein bekannt ist und B (r, $\vartheta$, $\varphi$,t) sich durch die Messung ergibt, kann $c_{nm}(t)$ ermittelt werden sodaß das mit Hilfe von $c_{nm}(t)$ gemäß Gleichung (1) zu berechnende Magnetfeld möglichst genau dem gemessenen Magnetfeld entspricht. Die Zahl der Meßpunkte, an denen das Magnetfeld B (r, $\vartheta$, $\varphi$,t) bestimmt werden muß, ist von der Zahl der Magnetfeldkomponenten abhängig, mit denen das gemessene Feld approximiert werden soll. Je höher die Zahl dieser Komponenten ist, desto höher ist auch die Zahl der erforderlichen Meßpunkte.

Es läßt sich zeigen, daß sich die zeitabhängigen Koeffizienten $c_{nm}(t)$ in folgender Form darstellen lassen:

$$c_{nm}(t) = I_{nm}(t)*i(t) \tag{4}$$

Dabei stellt der Operator * die Faltung (convolution) dar und $I_{nm}(t)$ die partielle Impulsantwort der Spule für die durch n,m definierte Magnetfeldkomponente, während i(t) der Strom ist, der in der Spule das gemessene Magnetfeld B (r, $\vartheta$, $\varphi$, t) erzeugt. $I_{nm}(t)$ stellt also den zeitlichen Verlauf der betreffenden, von der Spule erzeugten Magnetfeldkomponente dar, wenn sich der Strom durch die Spule zeitlich nach einer Delta-Funktion ändert. Da $c_{nm}(t)$ sich, wie zuvor erläutert, berechnen läßt und da i(t) bekannt ist, läßt sich aus Gleichung 4 die partielle Impulsantwort $I_{nm}(t)$ durch Entfaltung (deconvolution) oder verwandte Methoden ermitteln. Gemäß den vorstehenden Erläuterungen umfaßt das Verfahren zur Bestimmung der in dem Speicher 27 gespeicherten Impulsantworten somit folgende Schritte:

Zunächst wird im ersten Schritt (Block 101) der zeitliche Verlauf des Magnetfeldes B(r, $\vartheta$, $\varphi$, t) an einer Anzahl von Meßpunkten, vorzugsweise auf einer Kugeloberfläche gemessen, wobei gleichzeitig der Strom i(t) erfaßt wird, der dieses Magnetfeld hervorruft (Schritt 101). Aus dem so gemessenen Magnetfeld und den bekannten Kugelfunktionen

$Y_{nm}$ werden die zeitabhängigen Koeffizienten $c_{nm}(t)$ so bestimmt, daß der zeitliche Verlauf des damit gemäß Gleichung 1 errechenbaren Magnetfeldes möglichst gut mit dem zeitlichen Verlauf des an den Meßpunkten gemessenen Magnetfeldes übereinstimmt (Schritt 102). Aus den zeitabhängigen Koeffizienten $c_{nm}(t)$ wird im Schritt 103 für zumindest eine Komponente n,m die Impulsantwort $I_{nm}(t)$ unter Heranziehung von Gleichung 4 ermittelt. Diese Komponente wird im Schritt 104 im Speicher 27 gespeichert, und danach wird das Verfahren für die anderen Gradientenspulen wiederholt.

Das Verfahren zur Berechnung und Speicherung der partiellen Impulsantworten braucht nur einmal durchgeführt zu werden, wenn die Gradientenspulen nicht verändert werden. Die auf diese Weise gespeicherten Impulsantworten werden bei nachfolgenden Untersuchungen zur genauen Ermittlung des zeitlichen Verlaufs der von den Gradientenspulen erzeugten Magnetfelder, insbesondere ihrer sich linear ändernden Gradientenfelder, herangezogen. Mit den so berechneten Feldern läßt sich beispielsweise die Rekonstruktion verbessern.

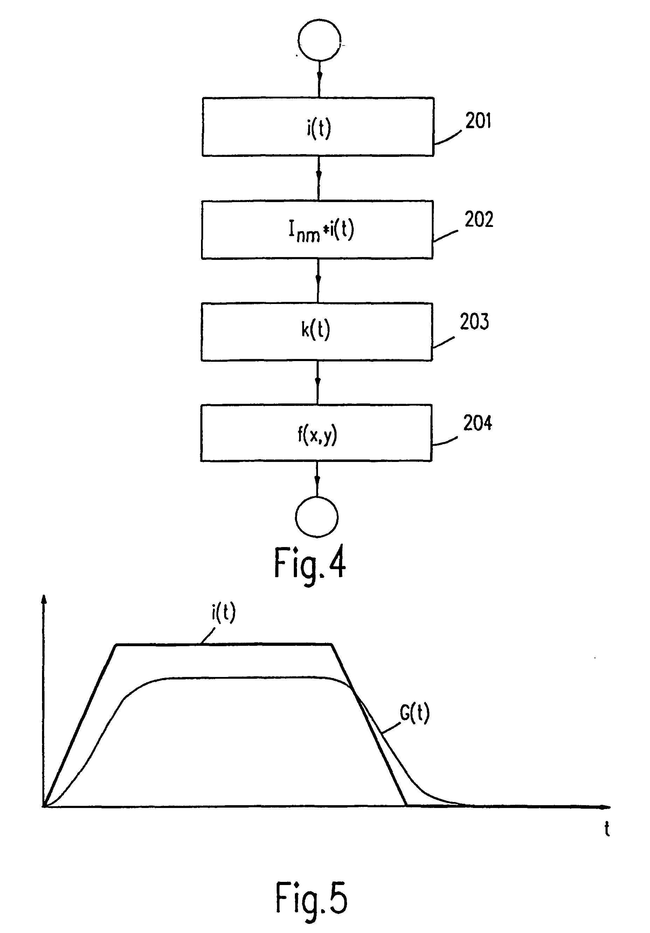

Fig. 4 zeigt das Ablaufdiagramm eines dafür geeigneten Verfahrens. Im ersten Schritt werden die zeitlichen Verläufe der während einer MR-Untersuchung durch die Gradientenspulen fließenden Ströme i(t) gemessen (Block 201). Fig. 5 zeigt einen typischen Verlauf des Stromes i(t) durch eine Gradientenspule.

Setzt man Gleichung (4) in Gleichung (1) ein, dann ergibt sich

$$B(r, \vartheta, \varphi, t) \approx \sum_{n=0}^{N} \sum_{m=-n}^{+n} [I_{nm}(t) * i(t)] \ Y_{nm}(r, \vartheta, \varphi) \qquad (5)$$

Für die Magnetfeldkomponente mit n = 1, m=1 ergibt sich wegen

$$P_{11}(\cos\vartheta) = \sin\vartheta \text{ und } r \sin\vartheta\cos\varphi = x$$

$$B(x, t) = [I_{11}(t) * i(t)] \ x \qquad (6)$$

B(x,t) ist also der zeitliche Verlauf eines Magnetfeldes mit einem konstanten Gradienten in x-Richtung. Dieser Rechenschritt 202 wird also durchgeführt, um den räumlich konstanten Gradienten $G_x(t)$ [= $I_{11}(t) * i(t)$] zu erhalten. Der auf diese Weise erhaltene tatsächliche zeitliche Verlauf des Gradientenfeldes $G_x(t)$ ist in Fig. 5 ebenfalls dargestellt. Man erkennt, daß - als Folge der Wirbelstromeffekte - G(t) gegenüber i(t) verzögert ist.

Analog ergeben sich die Gradienten für die y-Richtung, wenn man in Gleichung 6 die Impulsantwort $I_{11}(t)$ ersetzt durch $I_{1-1}(t)$, und der Gradient für die z-Richtung, wenn man in Gleichung 6 $I_{11}(t)$ ersetzt durch $I_{10}(t)$.

Nachdem auf diese Weise im Schritt 202 der zeitliche Verlauf des von den Gradientenspulen für die x-, y- und z-Richtung erzeugten Gradienten $G_x(t)$, $G_y(t)$ und $G_z(t)$ ermittelt worden ist, können die zugehörigen k-Werte berechnet werden (Block 203), weil die k-Werte bekanntlich das zeitliche Integral über den Gradienten G(t) darstellen. Mit den so erhaltenen k-Raum-Trajektorien läßt sich im Schritt 204 die Kernmagnetisierungsverteilung f(x,y) im Untersuchungsbereich, d.h. ein MR-Bild berechnen. Da die sich aus dem Schritt 203 ergebende Abtastung des k-Raums im allgemeinen von der idealen Form abweicht, muß zur Rekonstruktion ein Verfahren herangezogen werden, das - wie z.B. das bekannte Gridding-Verfahren - die ideale Abtastung (an äquidistanten Punkten im k-Raum) nicht voraussetzt.

Im allgemeinen erzeugen die Gradientenspulen neben einer linearen Komponente auch Komponenten höherer Ordnung. Wenn diese Komponenten nicht mehr vernachlässigbar sind und wenn zur Rekonstruktion ein Verfahren herangezogen wird, das nur auf den zeitlichen Verlauf des räumlich konstanten Gradienten abstellt, ergeben sich Fehler. Diese Fehler lassen sich beseitigen, wenn ein Rekonstruktionsverfahren herangezogen wird, das auch Komponenten höherer Ordnung berücksichtigt, und wenn im Schritt 203 auch diese Komponenten gemäß Gleichung 8 ermittelt werden.

Im Vorstehenden wurde davon ausgegangen, daß zur Bestimmung des zeitlichen Verlaufs eines von einer Gradientenspule erzeugten Magnetfeldes der in diese Gradientenspule hineinfließende Strom berücksichtigt wird. Grundsätzlich wäre es auch möglich, statt dessen den zeitlichen Verlauf der Spannung über der Gradientenspule zu messen. Dann wäre allerdings in Gleichung 4 bzw. im Schritt 103 (Fig. 3) die Impulsantwort $I_{nm}(t)$ abzuleiten aus den errechneten zeitabhängigen Koeffizienten $c_{nm}(t)$ und dem gemessenen Zeitverlauf der Spannung. Allerdings ist die Messung des zeitlichen Verlaufs des Stromes vorzuziehen, weil das Magnetfeld linear mit diesem Strom zusammenhängt.

Die Impulsantworten können entweder als Folge von numerischen Werten gespeichert werden oder, nachdem eine Anpassung mittels einer oder mehrerer Exponentialfunktionen erfolgt ist, als ein Satz von Amplitudenwerten mit zugehörigen Abkling-Zeitkonstanten. Letzteres hat den Vorteil, daß nur ein geringer numerischer Aufwand erforderlich ist.

Man kann den tatsächlichen Verlauf des von der Gradientenspule erzeugten Magnetfeldes auch mit Hilfe der Übertragungsfunktion der Gradientenspule ermitteln; bekanntlich läßt sich die Übertragungsfunktion aus der Impulsantwort durch eine Fourier-Transformation ableiten. Man erhält das Frequenzspektrum des Magnetfeldes, wenn man die Übertragungsfunktion mit dem Spektrum des gemessenen Stromes mulitpliziert (letzeres Spektrum erhält man aus dem gemessenen zeitlichen Verlauf des Stromes durch eine Fourier-Transformation). Durch eine weitere Fourier-Transformation ergibt sich aus dem Frequenzspektrum des Magnetfeldes dessen zeitlicher Verlauf.

**Patentansprüche**

1. MR-Verfahren mit folgenden Schritten,

   - Messung des zeitlichen Verlaufs des Stromes i(t) in bzw der Spannung an einer Gradientenspule während einer HR-Untersuchung,
   - Ermittlung des zeitlichen Verlaufes einer Komponente (n,m) des von der Gradientenspule erzeugten Magnetfeldes aus dem gemessenen zeitlichen Verlauf das stromes bzw. der Spannung und aus der Impulsantwort ($I_{nm}$(t)) - oder einer daraus abgeleiteten Größe - der Gradientenspule.

2. MR-Verfahren nach Anspruch 1, **gekennzeichnet durch folgende Schritte**

   a) Ermittlung des zeitlichen Verlaufs der sich räumlich linear ändernden Komponente des Magnetfeldes
   b) Rekonstruktion eines MR-Bildes aus den bei dem MR-Verfahren gewonnenen MR-Daten unter Berücksichtigung der ermittelten Komponente des magnetischen Gradientenfeldes.

3. MR-Verfahren nach Anspruch 2,
   **dadurch gekennzeichnet, daß** zusätzlich der zeitliche Verlauf der Komponenten höherer Ordnung ermittelt und bei der Rekonstruktion berücksichtigt wird.

4. MR-Verfahren nach Anspruch 1,
   **dadurch gekennzeichnet, daß** der zeitliche Verlauf des Magnetfeldes zum Design von ortsselektiven Hochfrequenzimpulsen verwendet wird.

5. MR-Gerät zur Durchführung des Verfahrens nach Anspruch 1, mit

   a) einem Hauptfeldmagneten (1) zur Erzeugung eines homogenen stationären Magnetfeldes,
   b) Gradienten-Spulenanordnungen (2...4) zur Erzeugung von magnetischen Gradientenfeldern mit in unterschiedlichen Richtungen verlaufenden Gradienten,
   c) einem Speicher, der die Impulsantwort - oder eine daraus abgeleitete Größe - j eder Gradientenspule enthält,
   d) einem Empfänger (9) zum Erfassen der im Untersuchungsbereich erzeugten MR-Signale,
   e) einer Rekonstruktionseinheit (24) zur Rekonstruktion der Kernmagnetisierungsverteilung im Untersuchungsbereich aus den MR-Signalen,

   **gekennzeichnet durch** wenigstens eine Meßeinheit zum Messen des zeitlichen Verlaufs des Stromes in oder der Spannung an jeder Gradientenspule während einer MR-Untersuchung und **durch** Mittel zum Ermitteln des zeitlichen Verlaufs einer Komponente (m,n) des Magnetfeldes der Gradientenspulen aus dem gemessenen zeitlichen Verlauf des Stromes bzw. der Spannung und den gespeicherten Impulsantworten, bzw. den daraus abgeleiteten Größen.

**Claims**

1. An MR method which includes the following steps:

   - measurement of the temporal variation of the current i(t) in or the voltage across a gradient coil during an MR examination,

- determination of the temporal variation of a component (n,m) of the magnetic field, generated by the gradient coil, from the measured temporal variation of the current or the voltage and from the pulse response ($I_{nm}$(t)) of the gradient coil, or from a quantity derived therefrom.

**2.** An MR method as claimed in Claim 1,
   **characterized in that** it includes the following steps:

   a) determination of the temporal variation of the spatially linearly varying component of the magnetic field,
   b) reconstruction of an MR image from the MR data acquired by way of the MR method, taking into account the magnetic gradient field component determined.

**3.** An MR method as claimed in Claim 2,
   **characterized in that** additionally the temporal variation of the higher-order components is determined and taken into account for the reconstruction.

**4.** An MR method as claimed in Claim 1,
   **characterized in that** the temporal variation of the magnetic field is used for the design of location-selective RF pulses.

**5.** An MR apparatus for carrying out the method claimed in Claim 1, including

   a) a main field magnet (1) for generating a uniform, steady magnetic field,
   b) gradient coil systems (2 ... 4) for generating magnetic gradient fields with gradients extending in different directions,
   c) a memory containing the pulse response, or a quantity derived therefrom, of each gradient coil,
   d) a receiver (9) for receiving the MR signals generated in the examination zone,
   e) a reconstruction unit (24) for the reconstruction of the nuclear magnetization distribution in the examination zone from the MR signals,

   **characterized in that** it includes at least one measuring unit for measuring the temporal variation of the current in or the voltage across each gradient coil during an MR examination, and means for determining the temporal variation of a component (m,n) of the magnetic field of the gradient coils from the measured temporal variation of the current or voltage and from the stored pulse responses, or from the quantities derived therefrom.

**Revendications**

**1.** Procédé par RM comportant les étapes suivantes :

   - mesure du tracé temporel du courant i(t) ou de la tension sur une bobine à gradient pendant un examen RM,
   - détermination du tracé temporel d'un composant (n, m) du champ magnétique produit par la bobine à gradient à partir du tracé temporel mesuré du courant ou de la tension et à partir de la réponse d'impulsion ($I_{nm}$(t)) - ou d'une grandeur dérivée de celle-ci - de la bobine à gradient.

**2.** Procédé par RM selon la revendication 1,
   <u>caractérisé par</u> les étapes suivantes

   a) détermination du tracé temporel des composants du champ magnétique variant linéairement dans l'espace;
   b) reconstruction d'une image RM à partir des données RM obtenues par le procédé par RM en prenant en considération les composants déterminés du champ à gradient magnétique.

**3.** Procédé par RM selon la revendication 2,
   <u>caractérisé en ce qu'</u>en plus, le tracé temporel des composants d'ordre supérieur est déterminé et pris en considération lors de la reconstruction.

**4.** Procédé par RM selon la revendication 1,
   <u>caractérisé en ce que</u> le tracé temporel du champ magnétique est utilisé pour la conception d'impulsions à haute fréquence spatialement sélectives.

5. Appareil RM d'exécution du procédé selon la revendication 1, avec

a) un aimant de champ principal (1) pour la production d'un champ magnétique stationnaire homogène;
b) des montages de bobines à gradient (2...4) pour la production de champs à gradient magnétiques avec des gradients s'étendant dans différentes directions;
c) une mémoire qui contient la réponse d'impulsion - ou une grandeur dérivée de celle-ci - de chaque bobine à gradient;
d) un récepteur (9) pour l'enregistrement des signaux RM produits dans la zone d'examen;
e) une unité de reconstruction (24) pour la reconstruction de la distribution de la magnétisation nucléaire dans la zone d'examen à partir des signaux RM,

**caractérisé par** au moins une unité de mesure pour la mesure du tracé temporel du courant dans chaque bobine à gradient ou de la tension sur chacune de celles-ci pendant un examen RM et par des moyens pour la détermination du tracé temporel d'un composant (m, n) du champ magnétique des bobines à gradient à partir du tracé temporel mesuré du courant ou de la tension et des réponses d'impulsion enregistrées ou des grandeurs dérivées de celles-ci.

Fig.1

Fig.2

Fig.3

10

Fig.4

Fig.5